# FASCICULE DE BREVET EUROPEEN

(11) **EP 2 914 958 B1**
(45) Date de publication et mention de la délivrance du brevet: **07.02.2018**
(21) Numéro de dépôt: 13789514.0
(22) Date de dépôt: 30.10.2013
(51) Int. Cl.: G01N 30/60, B01J 20/28, B01J 20/287, B01J 20/30, B01J 20/32, B01J 20/10

(54) **COLONNE DE CHROMATOGRAPHIE EN PHASE GAZEUSE COMPORTANT UNE PHASE STATIONNAIRE POREUSE**
GASCHROMATOGRAFIESÄULE MIT EINER PORÖSEN STATIONÄREN PHASE
GAS CHROMATOGRAPHY COLUMN COMPRISING A POROUS STATIONARY PHASE

(30) Priorité: 31.10.2012 FR 1260403
(43) Date de publication de la demande: 09.09.2015
(73) Titulaire: Commissariat à l'Énergie Atomique et aux Énergies Alternatives, 75015 Paris (FR)
(72) Inventeur: RICOUL, Florence, F-38950 Quaix-en-Chartreuse (FR); JOUSSEAUME, Vincent, F-38700 Le Sappey En Chartreuse (FR); MATHERON, Muriel, 73000 Chambery (FR)
(74) Mandataire: Brevalex
(86) Numéro de dépôt international: PCT/EP2013/072723
(87) Numéro de publication internationale: WO 2014/068004

(56) Documents cités:
- WO-A1-2004/065955
- WO-A1-2006/042727
- WO-A1-2011/110345
- DE-A1- 19 726 000
- SUN J ET AL: "A high resolution MEMS based gas chromatography column for the analysis of benzene and toluene gaseous mixtures", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, SWITZERLAND, vol. 141, no. 2, 7 septembre 2009 (2009-09-07), pages 431-435, XP026501688, ISSN: 0925-4005, DOI: 10.1016/J.SNB.2009.06.047 [extrait le 2009-07-09]
- NEHLSEN S ET AL: "Gas permeation properties of plasma polymerized thin film siloxane-type membranes for temperatures up to 350 DEG C", JOURNAL OF MEMBRANE SCIENCE, ELSEVIER SCIENTIFIC PUBL.COMPANY. AMSTERDAM, NL, vol. 106, no. 1, 13 octobre 1995 (1995-10-13), pages 1-7, XP004041261, ISSN: 0376-7388, DOI: 10.1016/0376-7388(95)00071-J
- JOUSSEAUME ET AL: "Porous ultra low k deposited by PECVD: From deposition to material properties", SURFACE AND COATINGS TECHNOLOGY, ELSEVIER, AMSTERDAM, NL, vol. 201, no. 22-23, 9 août 2007 (2007-08-09), pages 9248-9251, XP022191969, ISSN: 0257-8972, DOI: 10.1016/J.SURFCOAT.2007.04.105
- YU. V. PATRUSHEV ET AL: "A capillary gas chromatographic column with a porous layer based on a mesoporous material", RUSSIAN JOURNAL OF PHYSICAL CHEMISTRY A, vol. 82, no. 7, 1 juillet 2008 (2008-07-01), pages 1202-1205, XP055067647, ISSN: 0036-0244, DOI: 10.1134/S0036024408070261
- JI Z ET AL: "Porous layer open-tubular capillary columns: preparations, applications and future directions", JOURNAL OF CHROMATOGRAPHY, ELSEVIER SCIENCE PUBLISHERS B.V, NL, vol. 842, no. 1-2, 21 mai 1999 (1999-05-21), pages 115-142, XP004167268, ISSN: 0021-9673, DOI: 10.1016/S0021-9673(99)00126-0

## Description

### DOMAINE TECHNIQUE ET ART ANTÉRIEUR

La présente invention se rapporte aux colonnes de chromatographie en phase gazeuse comportant une phase stationnaire poreuse et conforme, et en particulier aux microcolonnes de chromatographie en phase gazeuse.

La technique de chromatographie en phase gazeuse est l'une des méthodes de séparation et d'analyse les plus utilisées pour les composés volatils ou semi-volatils. En particulier, lorsqu'elle est associée à la spectrométrie de masse, elle est la méthode de choix pour l'analyse de mélanges gazeux complexes dans de nombreux domaines, tels que l'environnement, la sécurité, l'industrie pharmaceutique, l'industrie agroalimentaire, ma pétrochimie...

Une colonne de chromatographie comporte en son sein une phase stationnaire présentant une certaine affinité avec les composés à analyser. C'est cette affinité qui permet de séparer les composés au sein de la colonne.

Cependant les équipements sont pour l'instant difficilement transportables et d'un coût élevé. Des recherches sont alors menées pour réduire la taille de ces équipements. Des colonnes de taille micrométrique pour la chromatographie en phase gazeuse ont été réalisées dans un substrat silicium.

La phase stationnaire est généralement formée après scellement d'un capot, par des procédés par voie liquide, pour chaque colonne séparément avec le dépôt d'un film de polymères, par exemple décrits dans le document Serrano, G., S.M. Reidy, and E.T. Zellers, Assessing the reliability of wall-coated microfabricated gas chromatographic separation columns. Sensors and Actuators B: Chemical, 2009. 141(1): p. 217-226*.* Cet technique présente les inconvénients de former une couche stationnaire présentant une mauvaise conformité, i.e. des zones de surépaisseur du film déposé dans les coins à cause d'effets capillaires, de faibles cadences et de faibles rendements de production puisque chaque colonne est fonctionnalisée séparément. En outre, ces procédés présentent une faible reproductibilité due aux aléas lors du séchage du polymère.

Pour pallier ces inconvénients, il a été envisagé de réaliser la phase stationnaire par un dépôt en phase gazeuse avant scellement d'un capot. Par exemple, les documents Lehman, U., et al. A miniuaturized gas chromatograph for autonomous and Longtime measurements. in Sensor 99. 1999 *et* Muller, J. and U. Lehmann, Trennsäule für eine miniaturisierten Gaschromatographen und verfahren zu deren Herstellung S.M. Technology, Editor. 1997*: Allemagne* décrivent la fonctionnalisation d'une colonne au moyen d'un dépôt chimique en phase vapeur assisté par plasma (ou PECVD, pour "Plasma-Enhanced Chemical Vapor Déposition" en anglais). Cependant, la phase stationnaire n'est pas poreuse. Le document Jousseaume V. , et al. Porous ultra low k deposited by PECVD: From deposition to material properties, Surface & Coatings Technology 201 (2007) p. 9248-9251 décrit la déposition d'une couche poreuse en SiOCH par PECVD, un agent porogène étant mis en oeuvre. WO2011/110345 décrit une microcolonne de chromatographie en phase gazeuse comportant une phase stationnaire en PDMS. DE 197 26 000 décrit la fabrication d'une colonne de chromatographie en phase gazeuse comportant une phase stationnaire poreuse.

### EXPOSÉ DE L'INVENTION

C'est par conséquent un but de la présente invention d'offrir une colonne de chromatographie comportant une phase stationnaire poreuse, dont la porosité est maîtrisée, dont le dépôt est conforme et assure une bonne efficacité de séparation.

Le but énoncé ci-dessus est atteint par une colonne de chromatographie en phase gazeuse comportant une phase stationnaire en SiOxCyHz poreux. Le fait de disposer d'une phase stationnaire poreuse augmente la surface développée de cette dernière, et favorise la rétention des espèces chimiques, ce qui améliore la séparation. De plus, les inventeurs estiment que plus la porosité est maîtrisée, meilleure sera la finesse des pics chromatographiques. On comprend alors que l'efficacité de la colonne sera améliorée : à longueur de colonne constante, la colonne pourra séparer davantage d'espèces chimiques.

Le coefficient x est compris entre 1 et 2 et de manière préférée entre 1,6 et 1,8. Le coefficient y est compris entre 0,8 et 3 et de préférence entre 1 et 2,2, et le coefficient z est compris entre 2,5 et 4,5 et de préférence entre 3 et 4, les bornes étant incluses.

Les inventeurs ont déterminé qu'en utilisant le SiOxCyHz avec les valeurs de x, y, z ci-dessus, celui-ci ayant une porosité comprise entre 10% et 40%, ils obtenaient formait une phase stationnaire particulièrement efficace. Rien ne permettait d'envisager que cette combinaison offrirait un matériau aussi adapté à réaliser une phase stationnaire. En effet le comportement d'un matériau en tant que phase stationnaire n'est pas prédictible, et les inventeurs ont effectué une triple sélection à la fois en sélectionnant le type de matériau, i.e. le SiOxCyHz, en sélectionnant le choix des valeurs des coefficients x, y, z et en sélectionnant le choix de la gamme de valeurs de la porosité du matériau aboutissant à l'obtention d'une phase stationnaire d'une grande efficacité de manière inattendue car rien ne laissait supposé que le choix des coefficients et le choix de la valeur de la porosité appliqué à ce matériau permettrait d'obtenir cette efficacité.

Ce matériau peut avantageusement être déposé par dépôt chimique en phase vapeur, ce qui permet d'obtenir un dépôt conforme. L'adjonction d'agents porogènes lors du dépôt de SiOxCyHz permet de maîtriser la porosité. De manière encore plus avantageuse, le matériau poreux peut être déposé par dépôt chimique en phase vapeur assisté par plasma, ce qui d'effectuer le dépôt à basse température et ainsi de conserver le caractère organique du matériau. Cela favorise l'adjonction d'agents porogènes.

En outre, la réalisation de la phase stationnaire par dépôt chimique en phase vapeur permet de réaliser collectivement plusieurs colonnes. De plus, une meilleure reproductibilité est obtenue.

La colonne de chromatographie selon l'invention permet de séparer au moins 4000 plateaux.

En outre, le SiCOH est utilisé en microélectronique dans les interconnections du fait de sa très faible constante diélectrique, ce qui offre l'avantage de disposer d'une technique de dépôt bien maîtrisée industriellement. Par ailleurs, les microcolonnes étant elles-mêmes réalisées par des procédés microélectroniques, le dépôt de SiOxCyHz s'intègre au procédé de réalisation des microcolonnes.

La présente invention a alors pour objet une colonne de chromatographie en phase gazeuse comportant un substrat, un canal formé dans ledit substrat, un couvercle fermant ledit substrat et une phase stationnaire recouvrant les parois dudit canal, ladite phase stationnaire étant en SiOxCyHz avec x compris entre 1 et 2, y compris entre 0,8 et 3 et z compris entre 2,5 et 4,5, les bornes étant incluses, les ladite phase stationnaire étant poreuse et présentant une porosité comprise entre 10% et 40%.

La colonne est avantageusement une microcolonne de chromatographie.

La phase stationnaire a de préférence une épaisseur comprise entre 50 nm et 1000 nm.

Par exemple, le substrat est en silicium et le capot est en verre ou en silicium.

La présente invention a également pour objet un procédé de fabrication d'une colonne de chromatographie en phase gazeuse selon la présente invention, comportant les étapes :
a) réalisation d'un canal dans un substrat,
b) formation d'une couche de SiOxCyHz sur les parois dudit canal, un agent porogène étant mis en oeuvre, par exemple du Norbornadiène, cette couche formant une couche stationnaire.
c) recuit pour éliminer l'agent porogène.
d) fermeture du canal par mise en place d'un capot.

L'étape b) est avantageusement réalisée par dépôt chimique en phase vapeur.

De manière encore plus avantageuse, l'étape b) peut être réalisée par dépôt chimique en phase vapeur assisté.

L'étape a) est par exemple réalisée par photolithographie et gravure.

Lors de l'étape b) du diéthoxyméthylsilane peut être utilisé comme précurseur.

Avantageusement, plusieurs colonnes sont fabriquées collectivement sur un même substrat, le substrat étant ensuite divisé de sorte à séparer les colonnes ainsi produites.

### BRÈVE DESCRIPTION DES DESSINS

La présente invention sera mieux comprise à l'aide de la description qui va suivre et des dessins sur lesquels :
- la figure 1A est une vue de dessus d'une microcolonne de chromatographie ;
- la figure 1B est une vue en coupe schématique d'une microcolonne de chromatographie représentée partiellement ;
- la figure 2 est une photo d'une coupe transversale d'une microcolonne de chromatographie comportant une phase stationnaire en SiOCH ;
- les figures 2A et 2B sont des vues agrandies d'un bord latérale et du fond respectivement du canal de la figure 2 ;
- la figure 3A représente un chromatogramme obtenus avec une microcolonne avec un dépôt de SiOCH poreux de 120 nm pour l'injection d'un mélange BTEX (benzène, Toluène, ethyl-benzène, o-xylène),présentant une porosité de 30%;
- la figure 3B représente un chromatogramme obtenu avec une microcolonne sans phase stationnaire pour l'injection d'un mélange BTEX (benzène, Toluène, ethyl-benzène, o-xylène),
- les figures 3C et 3D représentent des chronogrammes obtenus avec une microcolonne avec un dépôt de SiOCH poreux de 120 nm pour l'injection d'un mélange BTEX (benzène, Toluène, ethyl-benzène, o-xylène), présentant une porosité de 3% et 1% respectivement,
- les figures 4A et 4B représentent des chronogrammes obtenus avec une microcolonne avec un dépôt de SiOCH poreux pour l'injection d'un mélange C5-C7-Tol-C8 (pentane, heptane, toluène et octane) présentant une porosité de 33% et 20% respectivement.

### EXPOSÉ DÉTAILLÉ DE MODES DE RÉALISATION PARTICULIERS

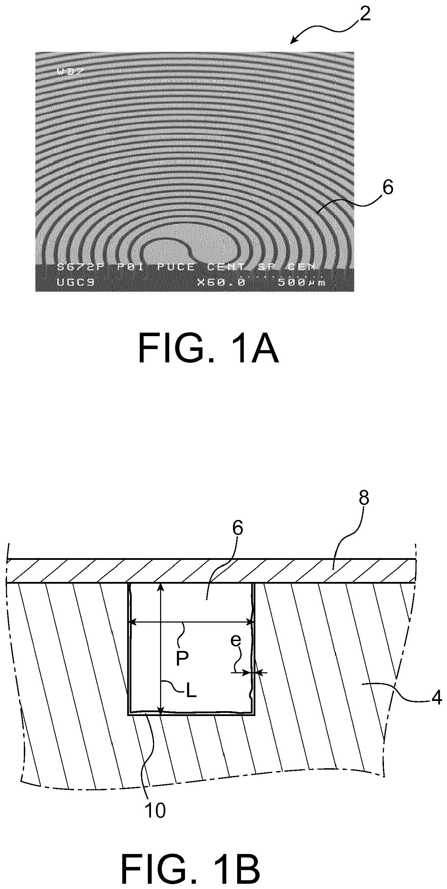

Sur la figure 1A, on peut voir une vue de dessus d'une microcolonne de chromatographie en phase gazeuse 2. Sur la figure 1B, on peut voir une coupe transversale de la microcolonne comportant un substrat 4 dans lequel est formé un canal 6 qui a généralement une section transversale rectangulaire, un capot 8 fermant de manière étanche le canal. Le capot 8 est fixé sur le substrat 4 par exemple par scellement anodique.

La colonne 2 comporte également Des extrémités de connexion fluidiques pour permettre la connexion ultérieure de la microcolonne à des équipements extérieurs tels qu'un système d'injection en entrée et un système d'analyse en sortie, via par exemple des capillaires.

Dans l'exemple représenté, le canal 6 a un profil en spiral, il s'agit d'une spiral présentant un double enroulement. Ainsi, les deux extrémités de connexion du canal peuvent être situées sur un bord du substrat. Le canal peut également avoir la forme d'un serpentin ou toute autre géométrie permettant d'optimiser la longueur du canal par rapport à la surface du substrat.

De préférence, le canal 6 présente un facteur de forme élevé, i.e. un rapport profondeur P sur largeur L de préférence supérieur à 1, de manière encore préférée supérieur à 10.

La microcolonne comporte également une phase stationnaire 10 recouvrant les parois du canal 6.

La phase stationnaire 10 est un composé de type SiOCH. Le terme désigne un composé de formule SiOxCyHz avec :
- x compris entre 1 et 2, de préférence entre 1,6 et 1,8,
- y compris entre 0,8 et 3, de préférence entre 1 et 2,2
- z compris entre 2,5 et 4,5, de préférence entre 3 et 4.

Le SiOxCyHz est rendu poreux. La couche de phase stationnaire 10 a de préférence une épaisseur e comprise entre 50 nm et 1000 nm, voire comprise entre 50 nm et 2000 nm.

Le SiOxCyHz présente une porosité ouverte, ce qui permet l'accès des espèces chimiques à séparer dans les pores.

De préférence, la porosité est comprise entre 10 % et 40%, voire entre 10 % et 60 %. Ce pourcentage représente le volume des pores pour un volume de matériau donné. De préférence les pores présentent un rayon compris entre 1 nm et 3 nm, voire compris entre 1 nm et 5 nm. Ces dimensions ont été observées par ellipsoporosimétrie, la molécule sonde étant le Toluène, le dispositif de mesure étant le modèle EP12 - société SOPRA.

Le SiOxCyHz peut avantageusement être déposé par dépôt chimique en phase vapeur ou CVD ("Chemical Vapor Déposition" en anglais). Le dépôt de SiOxCyHz est alors conforme, i.e. il présente une épaisseur homogène sur toute la longueur des parois.

En outre, l'ajout d'un agent porogène au cours du dépôt en phase vapeur permet de maîtriser la porosité et d'avoir une faible dispersion dans les pores de la phase stationnaire. Comme précédemment indiqué, le fait de maîtriser la taille, la dispersion en taille et la distribution spatiale des pores permet d'affiner les pics chromatographiques.

De manière encore plus avantageuse, il peut être déposé par dépôt chimique en phase vapeur assisté, par exemple par plasma, méthode connue sous l'acronyme PECVD ("Plasma-Enhanced Chemical Vapor Déposition" en anglais), ce qui permet d'obtenir un dépôt plus conforme que les techniques de pulvérisation de l'art antérieur. Ainsi, le dépôt par CVD ou CVD assisté sont bien adaptés aux canaux présentant un grand facteur de forme. On rappelle qu'un dépôt par PECVD, ou, de façon plus générale, par CVD assisté, permet d'effectuer le dépôt à basse température et ainsi de conserver le caractère organique du matériau. Cela favorise l'homogénéité de la distribution spatiale des agents porogènes et, in fine, l'homogénéité de la distribution spatiale des pores formés lors de l'élimination des agents porogènes.

Selon une variante avantageuse, le dépôt peut être réalisé par dépôt chimique en phase vapeur assisté par filament ou FACVD (Filament Assisted Enhanced Chemical Vapor Déposition" en anglais, ce qui permet d'optimiser la conformité.

Selon une autre variante, le dépôt peut être réalisé par dépôt chimique en phase vapeur d'une première couche comprenant le SiOCH et l'agent porogène, suivi par dépôt chimique en phase vapeur d'une deuxième couche de manière à constituer une deuxième couche étanche au gaz. On réalise ensuite une étape de moussage, qui permet la formation de pores dans la couche de SiOCH. La deuxième couche est ensuite éliminée.

Ce procédé est décrit dans la demande de brevet FR2918997. Il permet l'obtention de pores de taille plus élevée que les dépôts par CVD ou CVD assistés.

En outre, la réalisation de la phase stationnaire par dépôt CVD permet de réaliser collectivement plusieurs colonnes. De plus, une meilleure reproductibilité est obtenue.

Après l'étape de dépôt chimique en phase vapeur, l'agent porogène est éliminé par un procédé thermique (recuit), éventuellement assisté d'une irradiation UV. Durant cette étape, l'agent porogène disparaît, ce qui permet la formation de pores dans la matrice.

Selon un mode de réalisation, quel que soit le procédé de dépôt mis en oeuvre, la couche de SiOCH poreuse peut subir un post-traitement pour modifier les fonctions chimiques de surface. Cela permet d'ajuster la sélectivité de la phase stationnaire par rapport à un analyte donné. Un exemple de post traitement est l'application d'un plasma O₂, He, ou N₂O. Un autre exemple est une silanisation c'est-à-dire le greffage covalent de molécules organiques via une fonction silane.

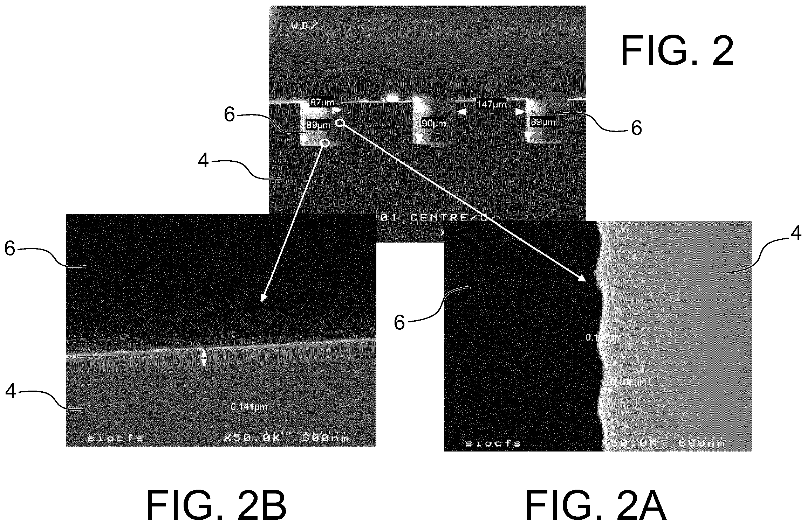

Sur la figure 2, on peut voir une photo d'une coupe transversale d'un canal 6, ménagé dans un substrat 4, le canal 6 étant recouvert d'une phase stationnaire 5 en SiOCH. Sur la figure 2A, on peut voir une vue agrandie d'un bord latéral du canal de la figure 2, dont l'épaisseur de la couche stationnaire est indiquée en deux endroits (0,100 µm et 0,106 µm) et sur la figure 2B, on peut avoir une vue agrandie du fond sur laquelle l'épaisseur de la couche stationnaire est 0,140 µm. La phase stationnaire est délimitée schématiquement par un trait interrompu. On constate donc une faible variation de cette épaisseur. Le calcul de la conformité est de 0,7 : il s'agit du rapport de l'épaisseur la plus faible de la couche sur l'épaisseur la plus forte, ces épaisseurs étant mesurées sur la section du canal. Par comparaison, lorsqu'on effectue un dépôt par voie liquide, la conformité observée est inférieure à 0,05. Sur le fond.

La réalisation de la phase stationnaire par dépôt chimique en phase vapeur permet une réalisation de plusieurs colonnes simultanément, par exemple dans le cas de microcolonnes réalisées dans un substrat en silicium. Les phases stationnaires de toutes les microcolonnes réalisées sur un wafer en silicium peuvent être réalisées simultanément.

En outre, le dépôt chimique en phase vapeur offre une bonne reproductibilité d'un wafer à l'autre.

Grâce à l'invention, on peut réaliser des colonnes offrant une bonne efficacité de séparation, par exemple plus de 4000 plateaux par mètre.

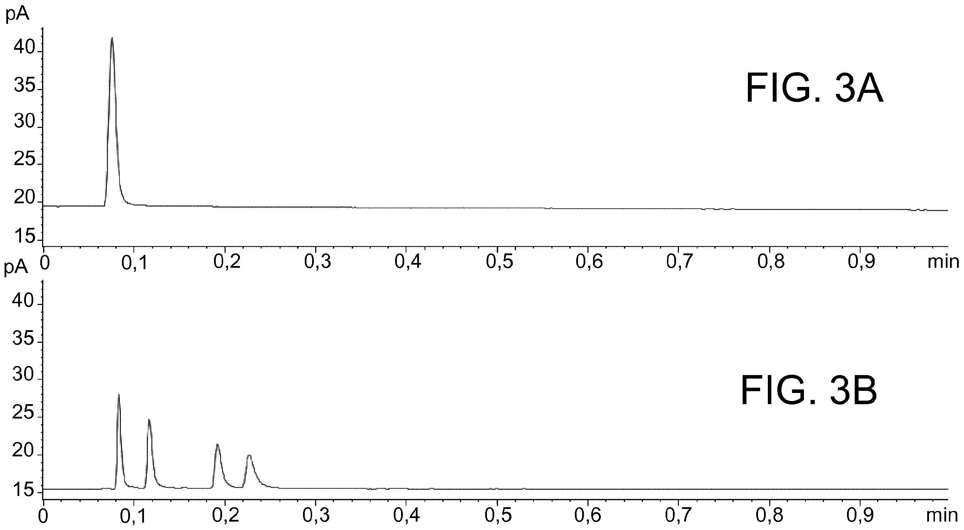

Sur la figure 3B, on peut voir un chromatogramme obtenu avec une microcolonne comportant une phase stationnaire en SiOCH poreux de 120 nm d'épaisseur, suite à l'injection d'un mélange BTEX (benzène, Toluène, ethyl-benzène, o-xylène), le SiOCH ayant une porosité de 30 %.

Les conditions d'injection sont les suivantes : la température de la colonne est 60 °C, le gaz vecteur est de l'hélium à 20 psi (c'est-à-dire un débit colonne d'environ 0,5 ml/min),0,01µl de mélange BTEX (soit environ ∼3,5 ng de chaque composé injecté sur la colonne).

Pour la réalisation des chromatogrammes, le détecteur branché en sortie de colonne est un détecteur de type FID; la colonne a une longueur de 1,3 m, une profondeur de 80 µm et une largeur de 80 µm.

Sur la figure 3A, le chromatogramme est obtenu avec une microcolonne sans phase stationnaire.

On constate que la colonne avec la phase stationnaire en SiOCH avec une porosité de 30% permet de séparer très efficacement les composés du mélange BTEX alors que la colonne sans phase stationnaire n'effectue aucune séparation.

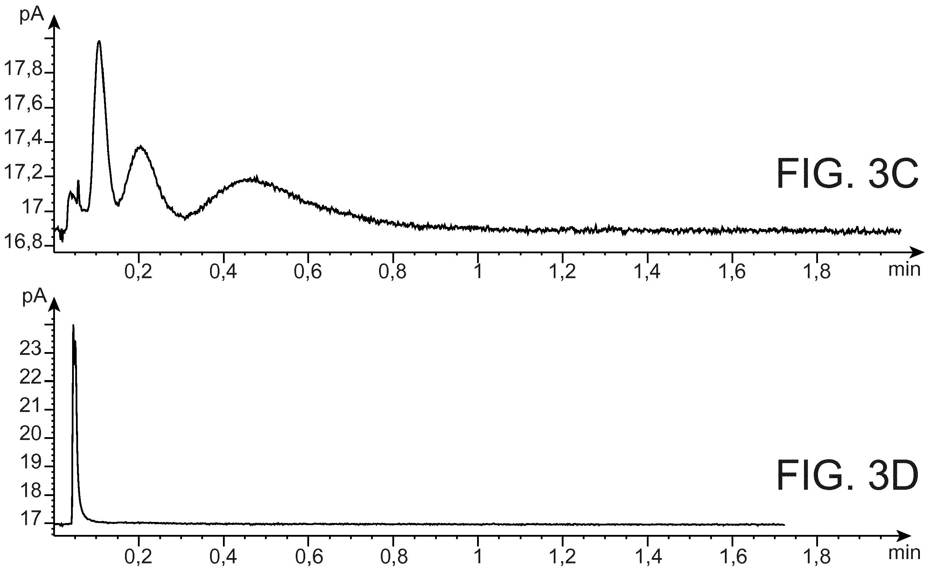

Les figures 3C et 3D représentent des chromatogrammes obtenus sur les mêmes microcolonnes que précédemment, avec respectivement un dépôt de SiOCH poreux avec 3% de porosité et un dépôt de SiOCH poreux avec 1 % de porosité pour l'injection d'un mélange BTEX (benzène, Toluène, ethyl-benzène, o-xylène).

On constate qu'une couche de SiOCH ayant une porosité de 3% n'assure pas une séparation satisfaisante des composés. Une colonne comportant une couche de SiOCH ayant une porosité de 1% est équivalent à une colonne sans couche stationnaire.

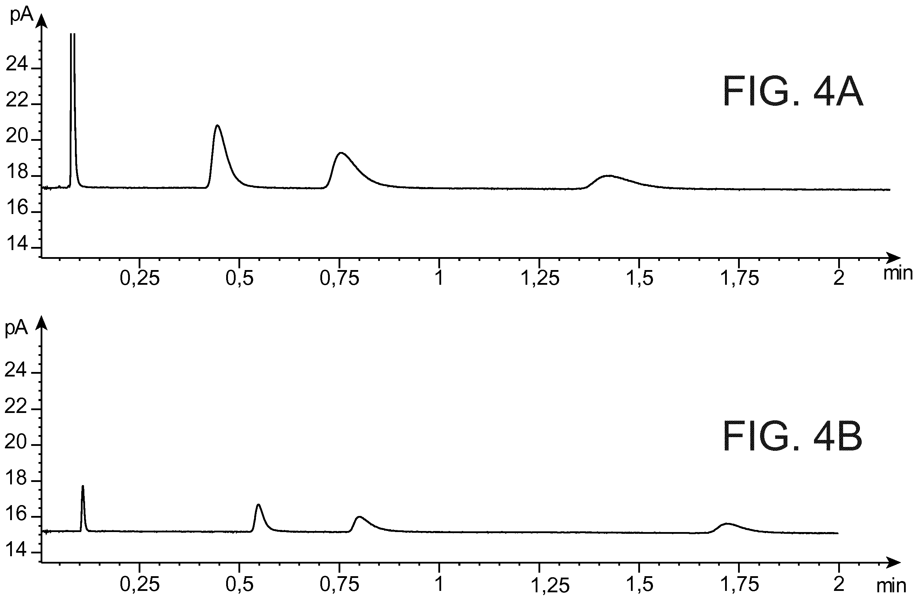

Sur les figures 4A et 4B, on peut voir des chronogrammes obtenus avec des microcolonnes selon l'invention. La surface intérieure de la colonne utilisée pour le chronogramme de la figure 4A est recouverte d'une phase stationnaire de SiOCH dont la porosité est 33%. La surface intérieure de la colonne utilisée pour le chronogramme de la figure 4B est recouverte d'une phase stationnaire de SiOCH dont la porosité est 20%.

Un mélange C5-C7-Tol-C8 (pentane, heptane, toluène et octane) est injecté, avec un débit de 0,5 ml/m, dans les colonnes dont la température de la colonne étant de 40°C.

Les figures 4A et 4B illustrent également l'efficacité des colonnes avec du SiOCH poreux selon l'invention dans la séparation des analytes, dans le cas présente, ceux du mélange C5-C7-Tol-C8.

Par conséquent, le choix du SiOxCyHz, des valeurs des coefficients x, y et z et de la valeur de la porosité permet de réaliser une couche stationnaire d'un grande efficacité et ceci de manière inattendue.

Nous allons maintenant décrire un exemple de procédé de réalisation de la microcolonne selon l'invention.

Dans cet exemple de réalisation, les microcolonnes sont réalisées dans un wafer de silicium. Plusieurs colonnes sont réalisées sur un même wafer, par exemple 35 colonnes peuvent être réalisées sur un même wafer.

Nous décrirons la réalisation d'une colonne, mais il sera compris que plusieurs colonnes peuvent être réalisées simultanément.

Lors d'une première étape, le canal est gravé dans le wafer en silicium.

Par exemple, on effectue une photolithographie puis une gravure, par exemple une gravure ionique réactive profonde ou DRIE ("Deep Reactive Ion Etching" en anglais).

Lors d'une étape suivante, la phase stationnaire en SiOCH est déposée, par exemple par PECVD, par exemple avec une installation Producer SE de la société Applied Materials.

On utilise par exemple comme précurseur pour la matrice du DEMS (diethoxyméthylsilane). On peut éventuellement utiliser aussi d'autres précurseurs organosilicés tel que le tetramethyl-cyclotetrasiloxane, le dimethyl-dioxiranyl-silane, le diethoxy-methyl-oxiranyl-silane, ...).

L'agent porogène est par exemple du Norbornadiène (NBD). D'autres agents porogènes peuvent être utilisés, par exemple de molécules organiques telles que le norbornène, l'alpha terpinène, le cyclohexène oxyde, le cyclopentène oxyde, le trivertal,

A titre d'exemple, les conditions utilisées pour le dépôt par PECVD sont :
- température du substrat : 300°C
- pression dans la chambre 7 Torr,
- puissance du plasma 630 W,
- flux de O₂175 sccm,
- flux de DEMS (de 100 à 2000 sccm),
- flux de NBD (de 0 à 2000 scm).

L'étape de dépôt est suivie d'une étape de recuit qui permet d'éliminer l'agent porogène et la formation des pores, puisque celui-ci ne résiste pas à la haute température, et de réticuler la matrice. Le substrat est par exemple soumis pendant quelques minutes sous UV à une température de l'ordre de 400°C.

Lors d'une étape suivante, un capot 8 par exemple en verre ou en silicium est scellé sur le substrat de sorte à fermer le canal 6. Celui-ci peut être scellé par exemple par scellement anodique, sérigraphie de colle, laminage d'un film polymérique, scellement moléculaire. Une étape de prétraitement des surfaces de scellement peut éventuellement avoir lieu avant le scellement. Ce peut être un traitement plasma (Hélium, Oxygène,...) ou traitement chimique désigné par le terme Piranha (application d'un mélange liquide H₂O₂ + H₂SO₄). Cela permet un nettoyage de surface, et par conséquent améliore le contact entre le substrat et le capot durant le scellement.

Dans le cas où l'on a réalisé simultanément plusieurs colonnes sur un même wafer, les colonnes ainsi réalisées munies de leur capot 8 sont découpées de manière à obtenir les microcolonnes individuelles.

A titre d'exemple, les dimensions des canaux sont : une profondeur h comprise entre 50 µm et 200µm, une longueur comprise entre 0,5 m et 3 m, et une largeur L comprise entre 20 µm et 120 µm.

Il sera compris que l'invention ne se limite pas aux microcolonnes de chromatographie en phase gazeuse mais à toute colonne de chromatographie en phase gazeuse. Néanmoins, elle présente un avantage supplémentaire pour les microcolonnes.

Dans le cas d'une colonne capillaire, la couche de SiOCH peut notamment être appliquée par voie sol-gel, l'agent porogène étant initialement mélangé dans le sol, puis éliminé après la gélification.

La colonne de chromatographie selon l'invention est destinée à former une partie d'un système d'analyse, servant à séparer les composés d'un mélange. Le mélange est transporté au sein de la colonne par un gaz vecteur, par exemple de l'hélium.

La colonne est donc destinée à être disposée entre un injecteur connecté en entrée de la colonne pour injecter le mélange à analyser, un système de régulation du gaz vecteur qui injecte le gaz vecteur dans la colonne et un détecteur qui est connecté en sortie de la colonne et analyse les composés séparés par la colonne. Un système de régulation de la température de la colonne peut être prévu.

Le système d'analyse ainsi formé peut être utilisées pour l'analyse de gaz dans différents domaines d'application tels que l'environnement, la sécurité, la santé, l'industrie pharmaceutique, l'agroalimentaire, la pétrochimie, etc.

## Revendications

1. Colonne de chromatographie en phase gazeuse comportant un substrat (4), un canal (6) formé dans ledit substrat (4), un capot (8) fermant ledit substrat (4) et une phase stationnaire (10) recouvrant les parois dudit canal (6), ladite phase stationnaire (10) étant en SiOxCyHz avec x compris entre 1 et 2, y compris entre 0,8 et 3 et z compris entre 2,5 et 4,5, les bornes étant incluses, ladite phase stationnaire ayant une porosité comprise entre 10% et 40%.

2. Colonne de chromatographie en phase gazeuse selon la revendication 1, étant une microcolonne de chromatographie.

3. Colonne de chromatographie en phase gazeuse selon la revendication 1 ou 2, dans laquelle la phase stationnaire (10) a une épaisseur comprise entre 50 nm et 1000 nm.

4. Colonne de chromatographie en phase gazeuse selon l'une des revendications 1 à 3, dans laquelle le substrat (4) est en silicium et le capot (8) est en verre ou en silicium.

5. Procédé de fabrication d'une colonne de chromatographie en phase gazeuse selon l'une des revendications 1 à 4, comportant les étapes:
a) réalisation d'un canal (6) dans un substrat (4),
b) formation d'une couche de SiOxCyHz sur les parois dudit canal (6), un agent porogène étant mis en oeuvre pendant la formation de la couche de SiOxCyHz, par exemple du Norbornadiène,
c) recuit pour éliminer l'agent porogène,
d) fermeture du canal (6) par mise en place d'un capot (8).

6. Procédé de fabrication selon la revendication 5, dans lequel l'étape b) est réalisée par dépôt chimique en phase vapeur.

7. Procédé de fabrication selon la revendication 5, dans lequel l'étape b) est réalisée par dépôt chimique en phase vapeur assisté.

8. Procédé de fabrication selon l'une des revendications 5 à 7, dans lequel l'étape a) est réalisée par photolithographie et gravure.

9. Procédé de fabrication selon l'une des revendications 5 à 8, dans lequel lors de l'étape b) du diéthoxyméthylsilane est utilisé comme précurseur.

10. Procédé de fabrication selon l'une des revendications 5 à 9, dans lequel plusieurs colonnes sont fabriquées collectivement sur un même substrat, le substrat étant ensuite divisé de sorte à séparer les colonnes ainsi produites.

## Patentansprüche

1. Gaschromatografiesäule umfassend ein Substrat (4), einen in dem Substrat (4) ausgebildeten Kanal (6), eine Abdeckung (8), die das Substrat (4) abschließt und eine stationäre Phase (10), die die Wände des Kanals (6) bedeckt, wobei die stationäre Phase (10) aus SiOxCyHz besteht, mit x im Bereich von 1 bis 2, y im Bereich von 0,8 bis 3 und z im Bereich von 2,5 bis 4,5, Grenzen eingeschlossen, wobei die stationäre Phase eine Porosität im Bereich von 10% bis 40 % aufweist.

2. Gaschromatografiesäule nach Anspruch 1, die eine Mikrochromatografiesäule ist.

3. Gaschromatografiesäule nach Anspruch 1 oder 2, wobei die stationäre Phase (10) eine Dicke im Bereich von 50 nm bis 1000 nm aufweist.

4. Gaschromatografiesäule nach einem der Ansprüche 1 bis 3, wobei das Substrat (4) aus Silicium besteht und die Abdeckung (8) aus Glas oder aus Silicium besteht.

5. Herstellungsverfahren einer Gaschromatografiesäule nach einem der Ansprüche 1 bis 4, umfassend die Schritte:
a) Herstellung eines Kanals (6) in einem Substrat (4),
b) Bildung einer Schicht von SiOxCyHz an den Wänden des Kanals (6), wobei ein Porenbildner während der Bildung der Schicht von SiOxCyHz eingesetzt wird, zum Beispiel Norbornadien,
c) Tempern, um den Porenbildner zu entfernen,
d) Verschließen des Kanals (6) durch Einsetzen einer Abdeckung (8).

6. Herstellungsverfahren nach Anspruch 5, wobei Schritt b) durch chemische Dampfabscheidung durchgeführt wird.

7. Herstellungsverfahren nach Anspruch 5, wobei Schritt b) durch unterstützte chemische Dampfabscheidung durchgeführt wird.

8. Herstellungsverfahren nach einem der Ansprüche 5 bis 7, wobei Schritt a) durch Fotolithographie und Ätzen durchgeführt wird.

9. Herstellungsverfahren nach einem der Ansprüche 5 bis 8, wobei bei Schritt b) Diethoxymethylsilan als Vorläufer verwendet wird.

10. Herstellungsverfahren nach einem der Ansprüche 5 bis 9, wobei mehrere Säulen gemeinsam auf dem gleichen Substrat hergestellt werden, wobei das Substrat anschließen so geteilt wird, dass die so hergestellten Säulen getrennt sind.

## Claims

1. Gas chromatography column comprising a substrate (4), a channel (6) formed in said substrate (4), a cap (8) closing said substrate (4) and a stationary phase (10) covering the walls of said channel (6), wherein said stationary phase (10) is made of SiOxCyHz with x between 1 and 2, y between 0.8 and 3 and z between 2.5 and 4.5, the limits of the ranges being included, said stationary phase having a porosity of between 10% and 40%.

2. Gas chromatography column according to claim 1, being a chromatography microcolumn.

3. Gas chromatography column according to claim 1 or 2, in which the stationary phase (10) has a thickness of between 50 nm and 1000 nm.

4. Gas chromatography column according to one of claims 1 to 3, in which the substrate (4) is made of silicon and the cap (8) is made of glass or silicon.

5. Method of manufacturing a gas chromatography column according to one of claims 1 to 4, comprising the steps of:
a) formation of a channel (6) in a substrate (4),
b) formation of a layer of SiOxCyHz on the walls of said channel (6), a pore-forming agent being implemented during the formation of the layer of SiOxCyHz, for example norbornadiene,
c) annealing to eliminate the pore-forming agent,
d) closing of the channel (6) by putting in place a cap (8).

6. Method of manufacture according to claim 5, in which step b) is carried out by chemical vapour deposition.

7. Method of manufacture according to claim 5, in which step b) is carried out by enhanced chemical vapour deposition.

8. Method of manufacture according to one of claims 5 to 7, in which step a) is carried out by photolithography and etching.

9. Method of manufacture according to one of claims 5 to 8, in which during step b) diethoxymethylsilane is used as precursor.

10. Method of manufacture according to one of claims 5 to 9, in which several columns are manufactured collectively on a same substrate, the substrate then being divided so as to separate the columns thereby produced.
